# EUROPEAN PATENT APPLICATION

(11) **EP 4 303 942 A1**
(43) Date of publication of application: **10.01.2024**
(21) Application number: 22762666.0
(22) Date of filing: 03.03.2022
(51) Int. Cl.: H01L 37/00, F25B 21/00, F25B 21/02

(54) **DEVICE FOR CONVERTING THERMAL ENERGY INTO ELECTRICAL OR MECHANICAL ENERGY USING MAGNETOCALORIC EFFECT**

(30) Priority: 05.03.2021 ES 202130200
(71) Applicant: EMSC Global Water Solutions, S.L., 28660 Boadille del Monte Madrid (ES)
(72) Inventor: PEÑAS BALLESTER, Pedro, 28660 BOADILLA DEL MONTE (Madrid) (ES); ABAD GARRIDO, Francisco Javier, 28660 BOADILLA DEL MONTE (Madrid) (ES); ARIAS JEREZ, Enrique, 28660 BOADILLA DEL MONTE (Madrid) (ES)
(74) Representative: Sahuquillo Huerta, Jesús
(86) International application number: PCT/ES2022/070120
(87) International publication number: WO 2022/184962

(57) **Abstract**

Disclosed is a device for converting thermal energy into electrical energy using the magnetocaloric effect, which comprises a shaft (1) with respect to which rotate a drum of magnets (11) and a drum of sheets (12) consisting of a cylinder (4) of a ferromagnetic material around the edge of which a plurality of sheets (5) of a material with magnetocaloric properties are disposed, such that, in a first operating mode as an electric generator, the drum (12) of plates is solidly connected to the shaft (1), while in a second operating mode as a mechanical generator, the drum of sheets (12) rotates freely with respect to the shaft (1) and to the drum of magnets (11).

## Description

### Technical field

The present invention relates to an electrical or mechanical energy generating device and, more particularly, to a device for generating electrical or mechanical energy from thermal energy communicated to the device by conduction, convection, or radiation.

### Prior art

At present there is a wide variety of electrical generators that use thermal energy to convert it into electrical energy. For example, there are devices that need a hot focus and a cold focus (indirect conversion devices) and where a heat source is needed at a certain temperature, as well as a cold source at a lower temperature, so that a fluid is needed that goes from a high temperature to a lower temperature. This is the case of mechanisms consisting of a turbine plus a conventional electric generator, as well as certain thermoelectric mechanisms that use the passage of thermal energy to generate an electric current.

However, other mechanisms that can convert thermal energy into electrical energy do not use two different temperatures, since they are capable of converting electrical energy from a heat source at a certain temperature. The best-known case is that of thermocouples, in which heat incident on a metal junction is automatically converted into electric current. This form represents the ideal way to convert heat into electric current, but it is not very efficient and has a capacity to generate very small electric currents, insufficient in any case to be a source of electrical energy.

The state of the art describes the use of two fluids at different temperatures to drive mechanisms for generating electricity from thermal energy. This is the case of magnetocaloric generators that use the magnetic properties of certain materials to change to a magnetized or demagnetized state depending on the temperature.

The magnetocaloric effect is a magneto-thermodynamic phenomenon in which a temperature change in a susceptible material occurs when that material is exposed to a variable magnetic field. This is known as adiabatic demagnetization. In such a part of the refrigeration cycle, a decrease in the strength of an externally applied magnetic field allows the magnetic domains of a magnetocaloric material to become disoriented by the magnetic stirring of phonons present in the material. If the material is insulated in such a way that no energy is allowed to enter from the outside during such disorganization, the temperature decreases as a result of heat absorption by these domains.

Some prior art documents describing the use of the magnetocaloric effect in the generation of electrical energy are described below.

US 8, 769, 966 B2 describes a thermal generator with at least one thermal module comprising at least two magnetic assemblies wherein one magnetic assembly subjects at least one magnetocaloric element of the thermal module to alternating magnetic phases. The thermal generator is further characterized in that it comprises a thermal insulating body that isolates the magnetic assemblies from each other and forms thermally insulated cells comprising a magnetic assembly and its corresponding magnetocaloric elements.

Patent US20100300118A1 describes a generator comprising at least one thermal stage having magnetocaloric elements arranged around a shaft and a magnetic arrangement supported by a drive shaft that rotates around the shaft to subject the elements to a variation in magnetic field. The generator comprises pistons for forcing heat transfer fluid through the elements with the pistons driven in reciprocating translation within the chambers by at least one cam which is rotationally driven by the drive shaft. The generator comprises a forced circulation unit having planetary gears arranged around the central shaft, supported by the generator body, and meshed with an inner ring gear integral with the cam. Each gear forms a gear pump that mixes the heat transfer fluid and places the fluid in forced circulation in the tanks and chambers.

Patent CN102197502B relates to a thermal generator comprising at least one thermal module including at least two adjacent magnetocaloric elements, a common distribution chamber combined with a fluid form coolant circulation means. connecting said magnetocaloric members to each other, and two end chambers also combined with a circulation means and each fluidly connected to the two magnetocaloric members located at the hot and cold ends of said thermal module, and a magnetic arrangement for subjecting each magnetocaloric member to a variable magnetic field, wherein said thermal generator is characterized in that said circulation means combined with said common distribution chamber move coolant simultaneously through the two adjacent magnetocaloric members in different directions.

Patent US20130106116A1 describes a thermomagnetic generator, which includes a switching valve, a plurality of magnetic circuit units, a coil and a plurality of inlet pipes connecting the magnetic circuit units to the switching valve. Each of the magnetic circuit units includes a magnetocaloric member. The switching valve repeatedly and alternately switches at a predetermined frequency to guide hot and cold fluids to the magnetic circuit units, so that the magnetocaloric members are magnetized and demagnetized, respectively, by the hot and cold fluids. The coil is coupled to at least one of the magnetic circuit units to obtain an induced voltage.

Patent US20110192836A1 describes a heat generator comprising at least one thermal module comprising a magnetocaloric element traversed by a heat transfer fluid and two hot and cold chambers arranged on either side of the magnetocaloric element and containing a displacement device for directing the heat transfer fluid through the magnetocaloric element. A magnetic arrangement creates a magnetic field variation in each magnetocaloric element. A device for driving the displacement device, according to reciprocating motion in the corresponding chamber, to displace the heat transfer fluid in synchronization with the magnetic field variation. The drive device contains a closed fluid circuit connecting the cold and hot chambers in which a working fluid is driven by a suction and discharge device.

In the above documents two temperatures or two heat sources are required. The device of claim 1, however, works with only one thermal focus. The thermal range will depend on the materials used. The use of a single thermal focus makes it possible to work at room temperature, above or below.

### Explanation of the invention

An object of the present invention is a mechanism which converts heat into electrical or mechanical energy by combination of the magnetocaloric and thermoelectric effects, based on the combination of a circular or linear trajectory movement of one or several magnets or magnetic field generating elements close to one or several sheets of a material with magnetocaloric properties. This object is achieved with the device of claim 1. Particular solutions and preferred embodiments of the invention are described in the dependent claims.

More specifically, the device converting thermal energy into electrical or mechanical energy by magnetocaloric effect is characterized in that it comprises an axis about which rotates a drum of magnets and a drum of sheets consisting, in turn, a cylinder of a ferromagnetic material on which are arranged peripherally a plurality of sheets of a material with magnetocaloric properties; in such a way that in a first mode of operation as an electrical generator the drum of blades is solidary with the shaft, while in a second mode of operation as a mechanical generator the drum of blades rotates freely with respect to the shaft and the drum of magnets.

The device of the invention converts the electrical energy generated in magnetocaloric sheets into circular motion through the coupling of electrons in the magnetic field caused by the position of the magnetic field generating magnets with respect to the sheets of magnetocaloric material and the electric current generated therein. Furthermore, the present invention makes it possible to take advantage of the magnetocaloric capacity of ferromagnetic materials, such as iron, to create monobloc mechanical rotors. Finally, the invention proposes a device which, when coupled to shafts of machines which generate internal heat, act as an electrical generator and as a cooler of the system in which they are coupled.

Therefore, the device of the invention is a direct system for generating electrical energy from thermal energy without requiring the existence of two different temperatures or sources. The difference of the proposed device with the previous known and existing ones is the possibility of generating large electric currents and powers directly from a heat source and with very high performances. These performances exceed those of the thermal-electric machines described in the state of the art. In the invention, for its operation, it is only necessary that there is only one heat source and, therefore, it is not necessary that there are two fluids at different temperatures, nor is it necessary the existence of a cold source, as in the machines of the prior art.

The magneto-thermal effect implies that a molecule -which has this physical property- is capable of storing energy within itself depending on the orientation of its magnetic spin. Thus, for example, it is observed that by varying the position of a magnetic field with respect to a molecule or crystalline structure with magnetocaloric properties, there is an absorption of heat from the outside into the crystalline structure or an evacuation of heat from the crystalline structure to the outside. If the heat dissipation effect occurs fast enough, it is observed that along with the heat, electrons are ejected from the crystal or molecular lattice due to the Thomson effect.

However, if the polarity of the variable magnetic field varies only in the direction vector, but does not vary in polarity, it follows that - by Lorentz's law - the electrons evacuated from the crystal lattice - due to the Thomson effect of the magnetocaloric effect - will tend to move all in the same direction or, at least, share a common vector component.

Therefore, it can be deduced that the variation in direction of a homopolar magnetic field (because the polarity never changes) in a cyclic manner produces within a molecular structure (with magnetocaloric properties) the cyclic absorption and evacuation of heat within that molecular or crystalline structure.

It also follows from this fact that the cyclic evacuation of heat from the molecular or crystalline structure causes the movement of electrons out of the crystalline or molecular structure in a cyclic manner. This movement of electrons is, in itself, an electric current which is usable as electrical energy, thus demonstrating the correct operation of the invention.

Throughout the description and claims the word "comprises" and variants thereof are not intended to exclude other technical features, additives, components, or steps. To those skilled in the art, other objects, advantages, and features of the invention will be apparent in part from the description and in part from the practice of the invention. The following examples and drawings are provided by way of illustration and are not intended to restrict the present invention. Furthermore, the present invention covers all possible combinations of particular and preferred embodiments indicated herein.

### Brief Description of the Drawings

The following is a very brief description of a series of drawings which help to better understand the invention, and which relate expressly to an embodiment of said invention, which is illustrated as a non-limiting example thereof.

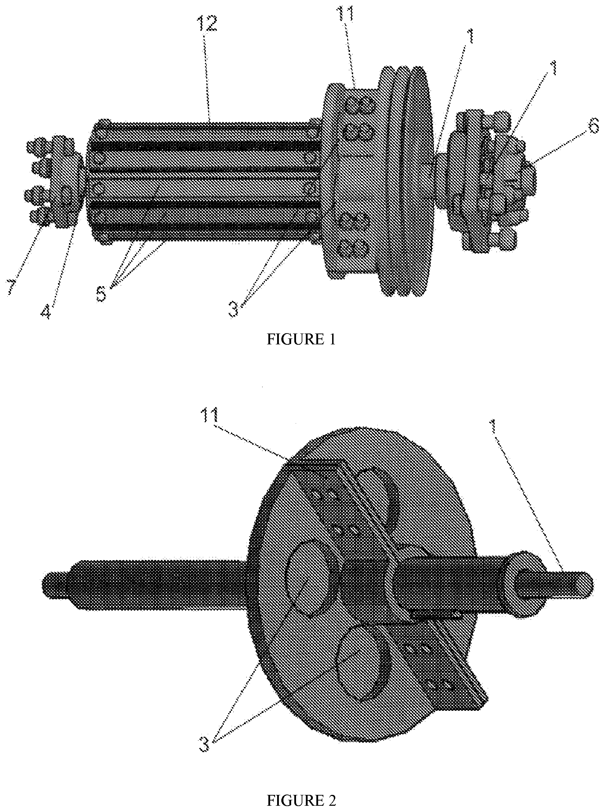

Figure 1 is a front longitudinal view of the described magnetocaloric thermal-to-electrical energy converter for a preferred embodiment of the present invention.
Figure 2 is a front longitudinal view of the magnet drum of the thermal-to-electrical energy converter by magnetocaloric way described, for a preferred embodiment of the present invention.

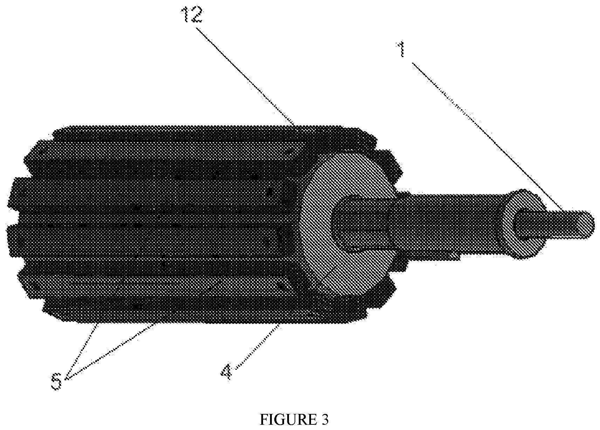

Figure 3 is a front longitudinal view of the reed drum of the thermal-to-electrical energy converter by magnetocaloric way described, for a preferred embodiment of the present invention.

### Detailed explanation of a mode of realization of the invention

As can be seen in the attached figures, in the device of the invention the following numerical references have been pointed out
1.- Shaft
3.- Magnets
4.- Cylinder of iron or other ferromagnetic material 5.
5.- Sheets of material with magnetocaloric properties
6.- First bearing
7.- Second bearing
11.- Drum of magnets
12.- Drum of sheets

With reference to the preferred embodiment of the device shown in the attached figures, the drum of magnets (11) is defined as an element rotating with respect to the axis (1) and housing at least two magnets (3) arranged angularly and equidistant with respect to the axis (1). In a particular embodiment of the invention, the magnets (3) are all positioned with the same polarity.

On the other hand, the drum of sheets (12) as a cylinder (4) of iron or other ferromagnetic material, wherein are arranged peripherally a plurality of sheets (5) of material with magnetocaloric properties, in a particular non-limiting embodiment, of titanium. The function of the cylinder (4) of iron or other ferromagnetic material is to confine the maximum possible magnetic flux density inside it.

The drum of sheets (12) has two basic modes of operation: electrical generator and mechanical generator. In the case of operation as an electrical generator, the drum of sheets (12) is solid with the shaft (1), while, in the case of operation as a mechanical generator, the drum of sheets (12) rotates freely with respect to the shaft (1) and the drum of magnets (11).

The sheets (5) that make up the drum of sheets (12) are elongated and narrow, in a non-limiting preferred embodiment, their dimensions are 10 mm wide, 0, 3 mm thick and 300 mm long, to thus assist and force the electrons to move in the desired direction. Each sheet (5) may be provided (or not) with a layer of aluminum or copper that serves to collect more efficiently the electrons that are evacuated from the crystalline structure with magnetocaloric properties.

Finally, the shaft can be anchored to a multitude of different support structures or to other shafts as required, generally by means of bearings (6, 7) which, together with sheets of resin or other material, as well as connecting pillars, form the frame that supports the assembly.

To explain the principle of operation of the device of the invention we have to consider that the sheets (5) of material with magnetocaloric properties have a non-homogeneous crystalline structure which is formed by a plurality of granules, as can be seen in the metallographs. Each granule, moreover, is made up of a hexagonal crystal structure, where each atom has its own magnetic vector. The orientation of the magnetic vector of each point of the crystalline or molecular structure of the sheets (5) will be influenced by the position of the magnets (3) of the drum of magnets (11).

If we move the drum of magnets (11) by the action of an external force, the magnetic vectors of each point of the crystalline structure also move. This implies that the thermal energy of each point of the crystalline structure undergoes a cyclic variation with respect to the cyclic variation of the position of the magnets. In other words, there is a positive and negative entropy variation.

This variation of the thermal energy necessarily leads to a cycle of absorption and evacuation of heat at each point of the crystalline structure and, therefore, if the thermal energy is sufficient, an ejection of electrons by the Thomson effect will occur during the evacuation cycle.

The movement of the magnets (3) with respect to the sheets (5) produces a second effect on the electrons expelled from the crystalline structure. As there is a relative movement of the electrons with respect to the magnetic field generated by the magnets (3), applying Lorentz's Law, it follows that a force perpendicular to the magnetic field and the speed of the magnets appears in the electrons, which "pushes" all the electrons to move in the same direction, creating an electric current, which can be used in different ways.

Therefore, the main energy that is used in the generation of electrons is the thermal energy that is evacuated by the magnetocaloric effect from the crystalline structure of the material that makes up the sheets (5). But there is also the mechanical energy that enters the mechanism through an external force that moves the magnets (3) with a certain speed. This force is added to the thermal force of electron generation by pushing them in the vectorial direction resulting from Lorentz's Law.

Therefore, it follows that there are two energy inputs (thermal energy to heat the sheets of magnetocaloric material and the mechanical energy to move the drum of magnets) and only one energy output, which is the one dragged by the electrons with themselves during their movement. Therefore, the only energy output is the electrical energy produced in the sheets (5) with magnetocaloric properties.

In the device of the invention, as described above, there are rotating parts which are subject to friction and consequent heat production. This means that part of the mechanical energy entering the system is transformed into heat due to friction, but this heat remains in the system and will be used to generate electrons from the crystalline structure of the sheets (5) with magnetocaloric properties. This effect represents the first main advantage of the system with respect to conventional mechanisms and is the theoretical potential it has to convert thermal energy into electrical energy with yields close to 100%.

Another main advantage with respect to other thermoelectric generation systems is that in this mechanism there are parameters that can be varied and conditioned to achieve sufficient electrical generation for domestic, industrial or any other use. These parameters would be the rotation speed of the magnets (3), which would increase the energy converted per unit of time. Other parameters are the size and quality of the magnetocaloric material sheets; the temperature to which the magnetocaloric sheets are subjected; and the sheets can be connected to each other in different ways to regulate the electrical energy generated.

In addition, each magnetocaloric material has its own operating parameters: minimum operating temperature; maximum operating temperature; and/or amount of heat converted into electricity per cycle.

This means that electrical generation mechanisms can be adapted to different operating temperatures, with the result that electricity can be generated even at temperatures below zero or at other temperatures considered to be cold. To better understand this, we can see how these magnetocaloric materials are used to work even at temperatures close to absolute zero, since they are used to cool the helium and nitrogen that serve as refrigeration for superconductors.

There is the possibility of using the mechanism of the invention to convert thermal energy into mechanical energy. If the sheets (5) of magnetocaloric material, are electrically connected with the sheet drum (12), the electric current flowing down or up (as the case may be) through the sheets (5) interacts with the magnetic field of the magnets (3) and as a consequence of Lorentz's Law, a tangential force is produced on the sheets (5) and the rotary motion of the sheet drum (12) is generated.

There is an alternative configuration for the case of using the magnetocaloric effect as a generator of mechanical rotation, since there are ferro-magnetic and magnetocaloric materials at the same time, such as iron. This means that it is possible to build a thermal generator by not using the magnetocaloric sheets (5) and making the cylinder (4) of ferromagnetic material of the drum of sheets (12) be made up of iron blades, as occurs with the rotors of squirrel cage electric motors. If the drum of sheets (12) is replaced by a squirrel cage rotor, the same motion described above would occur.

On the other hand, the device of the invention, by operating with the heat energy of a hot focus, can also act as a cooler when it is suitably inserted inside a machine which generates heat and whose heat it is necessary to evacuate. The use of a squirrel cage rotor as an electric generator, by magnetocaloric effect according to the arrangements described above, can be successfully used as a cooler for electric motors.

It is known that one of the main problems in electric motors is the evacuation of the heat they generate (cooling) to prevent them from reaching excessive temperatures that would cause the degradation of the electrical insulation and therefore their inability to operate. For this reason, all electric motors have ventilation blades attached to the shaft to generate a forced current of air for cooling. Instead of these blades, the device of the invention can be placed solidly attached to the shaft of the electric motor to generate electrical energy while cooling the electric motor. Thus, the applications of the present invention can be divided into its use for cooling or its use for electrical generation.

These mechanisms can be coupled to any rotating element for its cooling as well as energy recovery to increase the efficiency thereof. In addition, the invention can be coupled to any generator to increase the resulting energy produced and improve performance.

These mechanisms can operate as an isolated unit without being coupled to a motor or generator to generate mechanical or electrical energy as needed and as interfaced with the environment. For example, the mechanism may be provided with a crank to generate electrical power when the crank is operated manually, mechanically or by any means. The mechanism can also be provided with a propeller so that a fluid such as wind or water can be used to operate the generator. Another application is as an element in the power transmission line of a shaft that only works in one direction. The transmission of motion (in case the mechanism is used to generate mechanical power) only occurs from the drum of magnets (11) to the blade drum (12) and not in the opposite direction.

Finally, among the main advantages of the invention, we can highlight:
The magnetocaloric material is not subjected to a temperature difference, this simplifies the device since no elements intended to force a temperature difference to different elements of the mechanism are necessary.

The magnetocaloric material does not need to change from magnetic to non-magnetic phase. This greatly increases the number of magnetocaloric materials that can be used.

The working temperature can be any depending on the material used.

## Claims

1. A device for converting thermal energy into electrical or mechanical energy by magnetocaloric effect, **characterized in that** it comprises:
a shaft (1);
a drum of magnets (11) rotating with respect to the shaft (1); and
a drum of sheets (12) consisting, in turn, of a cylinder (4) of a ferromagnetic material on which are arranged peripherally a plurality of sheets (5) of a material with magnetocaloric properties; such that, in a first mode of operation as a generator of electrical energy, the drum of sheets (12) is solidary with the shaft (1), while in a second mode of operation as a generator of mechanical energy, the drum of sheets (12) rotates freely with respect to the shaft (1) and the drum of magnets (11).

2. The device of claim 1 wherein the drum of magnets (11) houses at least two magnets (3) arranged angularly and equidistant with respect to the shaft (1).

3. A method of converting thermal energy into electrical energy by magnetocaloric effect executable in the device of any one of claims 1 or 2 **characterized in that** it comprises:
arranging a drum of magnets (11) so as to rotate with respect to an axis (1); and
arranging concentrically with respect to the axis (1) a drum of sheets (12) on which a plurality of sheets (5) made of a material having magnetocaloric properties have been placed;
a first mode of operation as an electrical energy generator, wherein the drum of sheets (12) is solidary with the shaft (1) while the drum of magnets (11) rotates with respect to the shaft (1); and a second mode of operation as a mechanical energy generator, wherein the drum of sheets (12) rotates freely with respect to the shaft (1) and to the drum of magnets (11) which, in turn, also rotates with respect to the shaft (1).

4. The method according to claim 3, comprising housing at least two magnets (3) arranged angularly and equidistant with respect to the shaft (1) in the drum of magnets (11).
